# EUROPEAN PATENT SPECIFICATION

(11) **EP 4 303 779 B1**
(45) Date of publication and mention of the grant of the patent: **25.03.2026**
(21) Application number: 23153413.2
(22) Date of filing: 26.01.2023
(51) Int. Cl.: G06N 10/40

(54) **ELECTRONIC CIRCUIT AND CALCULATING DEVICE**
ELEKTRONISCHE SCHALTUNG UND BERECHNUNGSVORRICHTUNG
CIRCUIT ÉLECTRONIQUE ET DISPOSITIF DE CALCUL

(30) Priority: 07.07.2022 JP 2022109576
(43) Date of publication of application: 10.01.2024
(73) Proprietor: KABUSHIKI KAISHA TOSHIBA, Minato-ku Tokyo 105-0023 (JP)
(72) Inventor: GOTO, Hayato, Minato-ku, Tokyo 105-0023 (JP); HO, Yinghao, Minato-ku, Tokyo 105-0023 (JP); SHIOKAWA, Noritsugu, Minato-ku, Tokyo 105-0023 (JP); KAWAGUCHI, Tamio, Minato-ku, Tokyo 105-0023 (JP)
(74) Representative: Hoffmann Eitle

(56) References cited:
- GOTO HAYATO: "Double-Transmon Coupler: Fast Two-Qubit Gate with No Residual Coupling for Highly Detuned Superconducting Qubits", vol. 18, no. 3, 23 March 2022 (2022-03-23), pages 1 - 9, XP093058885, Retrieved from the Internet <URL:https://arxiv.org/pdf/2203.11451v1.pdf> DOI: 10.1103/PhysRevApplied.18.034038
- AGNETTA Y CLELAND ET AL: "Mechanical Purcell Filters for Microwave Quantum Machines", ARXIV.ORG, CORNELL UNIVERSITY LIBRARY, 201 OLIN LIBRARY CORNELL UNIVERSITY ITHACA, NY 14853, 21 May 2019 (2019-05-21), XP081588311, DOI: 10.1063/1.5111151
- EYOB A. SETE ET AL: "Quantum theory of a bandpass Purcell filter for qubit readout", ARXIV:1504.06030V2, 22 July 2015 (2015-07-22), XP055640821, Retrieved from the Internet <URL:https://arxiv.org/abs/1504.06030v2> [retrieved on 20191108], DOI: 10.1103/PhysRevA.92.012325

## Description

### FIELD

Embodiments described herein relate generally to an electronic circuit and a calculating device.

### BACKGROUND

For example, an electronic circuit that includes multiple nonlinear elements is used in a calculating device. It is desirable to improve the characteristics of the electronic circuit and the calculating device.

Goto Hayato: "Double-Transmon Coupler: Fast Two-Qubit Gate with No Residual Coupling for Highly Detuned Superconducting Qubits" relates to a tunable coupler for superconducting quantum computers, more specifically a double-transmon coupler consisting of two fixed-frequency transmons coupled through a common loop with an additional Josephson junction.

AGNETTA Y CLELAND ET AL: "Mechanical Purcell Filters for Microwave Quantum Machines" relates to a Purcell filter which forbids signal propagation at the qubit transition frequency. The filter is matched at the readout cavity frequency to protect the qubit from decoherence channels.

Eyob A. Sete ET AL: "Quantum theory of a bandpass Purcell filter for qubit readout" relates to semiclassical and quantum analyses for a bandpass Purcell filter.

### BRIEF DESCRIPTION OF THE DRAWINGS

FIG. 1 is a schematic plan view illustrating an electronic circuit according to a first embodiment;
FIG. 2 is a circuit diagram illustrating the electronic circuit according to the first embodiment;
FIG. 3 is a schematic view illustrating characteristics of the electronic circuit according to the first embodiment;
FIG. 4 is a schematic plan view illustrating an electronic circuit according to the first embodiment;
FIG. 5 is a schematic plan view illustrating an electronic circuit according to the first embodiment;
FIG. 6 is a schematic plan view illustrating an electronic circuit according to the first embodiment;
FIGS. 7A to 7E are schematic cross-sectional views illustrating portions of the electronic circuit according to the first embodiment;
FIGS. 8A to 8C are schematic cross-sectional views illustrating portions of the electronic circuit according to the first embodiment;
FIGS. 9A and 9B are schematic cross-sectional views illustrating portions of the electronic circuit according to the first embodiment;
FIGS. 10A and 10B are schematic cross-sectional views illustrating portions of the electronic circuit according to the first embodiment;
FIG. 11 is a schematic plan view illustrating an electronic circuit according to the first embodiment;
FIG. 12 is a schematic plan view illustrating an electronic circuit according to the first embodiment;
FIG. 13 is a schematic cross-sectional view illustrating the electronic circuit according to the first embodiment;
FIG. 14 is a graph illustrating characteristics of the electronic circuit according to the first embodiment;
FIG. 15 is a graph illustrating characteristics of the electronic circuit according to the first embodiment;
FIG. 16 is a schematic view illustrating an electronic circuit according to the first embodiment;
FIG. 17 is a schematic view illustrating an electronic circuit according to the first embodiment; and
FIG. 18 is a schematic view illustrating an electronic circuit and a calculating device according to a second embodiment.

### DETAILED DESCRIPTION

The object of the invention is achieved by the subject-matter of the independent claims. Advantageous embodiments are defined in the dependent claims. Further examples are provided for facilitating the understanding of the invention. According to the present disclosure, an electronic circuit includes a first qubit, a second qubit, a first coupler, a first readout conductive member, and a first filter. The first coupler includes a first resonator and a second resonator. The first resonator is couplable with the first qubit. The second resonator is couplable with the second qubit. The first filter includes a first filter portion, a first other-filter portion, and a first readout portion. The first filter portion is couplable with the first resonator. The first other-filter portion is couplable with the second resonator. The first readout portion is couplable with the first readout conductive member.

Various embodiments are described below with reference to the accompanying drawings.

The drawings are schematic and conceptual; and the relationships between the thickness and width of portions, the proportions of sizes among portions, etc., are not necessarily the same as the actual values. The dimensions and proportions may be illustrated differently among drawings, even for identical portions.

In the specification and drawings, components similar to those described previously or illustrated in an antecedent drawing are marked with like reference numerals, and a detailed description is omitted as appropriate.

### First embodiment

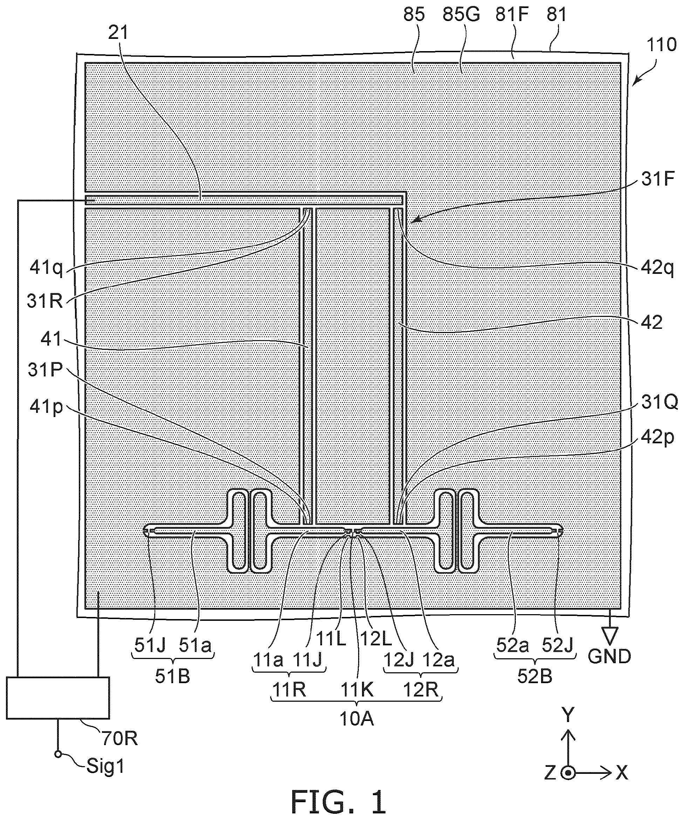

FIG. 1 is a schematic plan view illustrating an electronic circuit according to a first embodiment.

As shown in FIG. 1, the electronic circuit 110 according to the embodiment includes a first qubit 51B, a second qubit 52B, a first coupler 10A, a first readout conductive member 21, and a first filter 31F.

The first coupler 10A includes a first resonator 11R and a second resonator 12R. The first resonator 11R is couplable with the first qubit 51B. The second resonator 12R is couplable with the second qubit 52B. For example, the first resonator 11R is electromagnetically couplable with the first qubit 51B. For example, the second resonator 12R is electromagnetically couplable with the second qubit 52B. Electromagnetic coupling includes, for example, capacitive coupling. Electromagnetic coupling includes, for example, inductive coupling. The first coupler 10A is, for example, a tunable coupler.

The first filter 31F includes a first filter portion 31P, a first other-filter portion 31Q, and a first readout portion 31R. The first filter portion 31P is couplable with the first resonator 11R. The first other-filter portion 31Q is couplable with the second resonator 12R. The first readout portion 31R is couplable with the first readout conductive member 21. The first filter 31F may be, for example, a Purcell filter.

According to the invention, the states of the qubits are read out by the first readout conductive member 21 via the first filter 31F. Thereby, for example, qubits and couplers can be provided at high density.

For example, in a first reference example, the states of the qubits are read out via a readout resonator. In the first reference example, the surface area of the readout resonator is large, and space is necessary. It is therefore difficult to provide multiple qubits at high density.

In contrast, according to the invention, the first filter 31F and the resonators included in the first coupler 10A are coupled. The states of the qubits are read out via the couplers and the first filter 31F. According to the invention, the readout resonator can be omitted. Better space conservation is possible. High density qubits are obtained. According to the embodiment, an electronic circuit can be provided in which the characteristics can be improved.

In the example as shown in FIG. 1, the first filter 31F includes a first conductive member 41 and a second conductive member 42. The first conductive member 41 includes a first conductive portion 41p and a first other-conductive portion 41q. The second conductive member 42 includes a second conductive portion 42p and a second other-conductive portion 42q. The first conductive portion 41p is couplable with the first resonator 11R. The second conductive portion 42p is couplable with the second resonator 12R. The first other-conductive portion 41q is couplable with the first readout conductive member 21. The second other-conductive portion 42q is couplable with the first readout conductive member 21.

The first conductive portion 41p corresponds to the first filter portion 31P. The second conductive portion 42p corresponds to the first other-filter portion 31Q. At least one of the first other-conductive portion 41q or the second other-conductive portion 42q corresponds to the first readout portion 31R.

For example, the first qubit 51B, the second qubit 52B, the first coupler 10A, the first readout conductive member 21, and the first filter 31F may be formed from a conductive layer 85 located at a first surface 81F of a first base body 81. As described below, for example, at least a portion of the conductive layer 85 may be located at different multiple base bodies.

As shown in FIG. 1, the first coupler 10A includes a first coupler Josephson junction 11K. One end of the first coupler Josephson junction 11K is connected with the first resonator 11R. The other end of the first coupler Josephson junction 11K is connected with the second resonator 12R.

The first resonator 11R includes a first inductor 11L. The second resonator 12R includes a second inductor 12L. In the example, a first resonator Josephson junction 11J is used as the first inductor 11L. In the example, a second resonator Josephson junction 12J is used as the second inductor 12L.

The first resonator 11R is, for example, a first transmon resonator. The second resonator 12R is, for example, a second transmon resonator. The first coupler 10A is, for example, a double-transmon coupler.

A first resonator conductive part 11a that is connected with the first inductor 11L (the first resonator Josephson junction 11J) is included. A second resonator conductive part 12a that is connected with the second inductor 12L (the second resonator Josephson junction 12J) is included.

The first filter portion 31P of the first filter 31F is couplable with the first resonator conductive part 11a. The first other-filter portion 31Q of the first filter 31F is couplable with the second resonator conductive part 12a. The first resonator conductive part 11a and the first inductor 11L (the first resonator Josephson junction 11J) are included in the first resonator 11R. The second resonator conductive part 12a and the second inductor 12L (the second resonator Josephson junction 12J) are included in the second resonator 12R.

As shown in FIG. 1, the first qubit 51B includes a first bit Josephson junction 51J and a first bit conductive part 51a. The first bit conductive part 51a is connected with the first bit Josephson junction 51J. The second qubit 52B includes a second bit Josephson junction 52J and a second bit conductive part 52a. The second bit conductive part 52a is connected with the second bit Josephson junction 52J.

The first bit conductive part 51a is couplable with the first resonator conductive part 11a. The second bit conductive part 52a is couplable with the second resonator conductive part 12a.

A ground conductive layer 85G that is formed from the conductive layer 85 may be included. The ground conductive layer 85G is set to a ground potential GND (e.g., a reference potential). For example, the ground conductive layer 85G may be located around the conductive layer 85 used to form the first qubit 51B, the second qubit 52B, the first coupler 10A, the first readout conductive member 21, and the first filter 31F.

A readout circuit 70R may be included as shown in FIG. 1. For example, the readout circuit 70R may be included in the electronic circuit 110. The readout circuit 70R may be located separately from the electronic circuit 110. The readout circuit 70R is electrically connected with the first readout conductive member 21. The readout circuit 70R is configured to detect the state of the first qubit 51B and the state of the second qubit 52B based on a signal obtained from the first readout conductive member 21. For example, the readout circuit 70R detects an output signal based on an input signal that is input to the first readout conductive member 21. The state of the first qubit 51B and the state of the second qubit 52B can be detected thereby. The readout circuit 70R outputs an output signal Sig1 including the detection result.

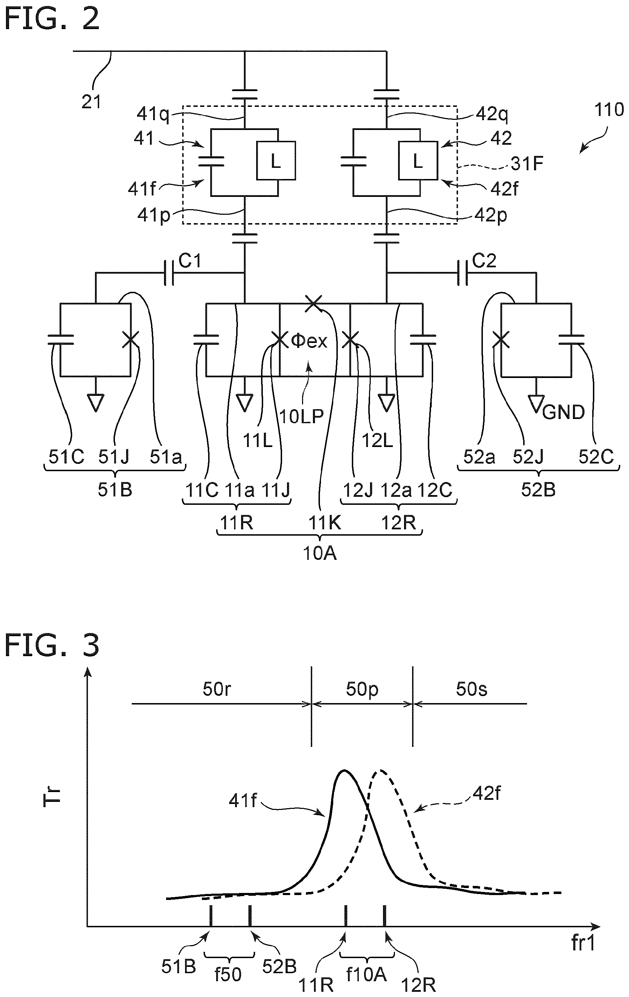

FIG. 2 is a circuit diagram illustrating the electronic circuit according to the first embodiment.

As shown in FIG. 2, the first resonator 11R includes the first inductor 11L and a first capacitor 11C. The first capacitor 11C is connected in parallel with the first inductor 11L. In the example as described above, the first resonator Josephson junction 11J is provided as the first inductor 11L. The first capacitor 11C is connected in parallel with the first resonator Josephson junction 11J.

The second resonator 12R includes the second inductor 12L and a second capacitor 12C. The second capacitor 12C is connected in parallel with the second inductor 12L. In the example as described above, the second resonator Josephson junction 12J is provided as the second inductor 12L. The second capacitor 12C is connected in parallel with the second resonator Josephson junction 12J.

The first coupler 10A further includes the first coupler Josephson junction 11K. One end of the first coupler Josephson junction 11K is connected with one end of the first inductor 11L and one end of the first capacitor 11C. The other end of the first coupler Josephson junction 11K is connected with one end of the second inductor 12L and one end of the second capacitor 12C.

The other end of the first inductor 11L and the other end of the first capacitor 11C are set to the ground potential GND. The other end of the second inductor 12L and the other end of the second capacitor 12C are set to the ground potential GND.

The first inductor 11L includes at least one first resonator Josephson junction 11J. The first inductor 11L may include multiple first resonator Josephson junctions 11J. The second inductor 12L includes at least one second resonator Josephson junction 12J. The second inductor 12L may include multiple second resonator Josephson junctions 12J.

The first qubit 51B includes the first bit Josephson junction 51J and a first bit capacitor 51C. The first bit capacitor 51C is connected in parallel with the first bit Josephson junction 51J. One end of the first bit Josephson junction 51J and one end of the first bit capacitor 51C are connected with the first bit conductive part 51a. The first bit conductive part 51a is couplable with the first resonator conductive part 11a. The other end of the first bit Josephson junction 51J and the other end of the first bit capacitor 51C are set to the ground potential GND.

The second qubit 52B includes the second bit Josephson junction 52J and a second bit capacitor 52C. The second bit capacitor 52C is connected in parallel with the second bit Josephson junction 52J. One end of the second bit Josephson junction 52J and one end of the second bit capacitor 52C are connected with the second bit conductive part 52a. The second bit conductive part 52a is couplable with the second resonator conductive part 12a. The other end of the second bit Josephson junction 52J and the other end of the second bit capacitor 52C are set to the ground potential GND.

A capacitance C1 may be formed of the first bit conductive part 51a and the first resonator conductive part 11a. A capacitance C2 may be formed of the second bit conductive part 52a and the second resonator conductive part 12a.

For example, the first conductive member 41 can be considered to be an LC circuit connected in parallel. For example, the first conductive member 41 corresponds to a first filter resonator 41f. For example, the second conductive member 42 can be considered to be an LC circuit connected in parallel. For example, the second conductive member 42 corresponds to a second filter resonator 42f. These LC circuits are waveguide resonators.

In one example, the resonant frequency of the first qubit 51B is about 8.3 GHz. The resonant frequency of the second qubit 52B is about 9.0 GHz. The resonant frequency of the first resonator 11R is about 11.0 GHz. The resonant frequency of the second resonator 12R is about 11.7 GHz. The frequency of the first resonator 11R is different from the resonant frequency of the second resonator 12R. The resonant frequency of the first resonator 11R and the resonant frequency of the second resonator 12R are read out via the first filter 31F. The resonant frequency of the first qubit 51B and the resonant frequency of the second qubit 52B are substantially cut off by a first filter 31.

According to the embodiment, for example, the resonant frequency of the first resonator 11R is greater than the resonant frequency of the first qubit 51B. The resonant frequency of the second resonator 12R is greater than the resonant frequency of the second qubit 52B.

As shown in FIG. 2, a loop 10LP is located in the first coupler 10A. The loop 10LP includes a conductive path including the first coupler Josephson junction 11K, a conductive path including the first resonator Josephson junction 11J, and a conductive path including the second resonator Josephson junction 12J. For example, the coupling strength between the first qubit 51B and the second qubit 52B can be controlled by controlling magnetic flux Φ inside the loop 10LP. The magnetic flux Φ inside the loop 10LP may be controlled by a magnetic flux controller 60 described below.

For example, the coupling between the first qubit 51B and the second qubit 52B can be substantially switched off. This state is, for example, an idling state. In the idling state, the first resonator 11R is considered to be a resonator strongly coupled with the first qubit 51B. The first resonator 11R can function as a readout resonator. According to the invention, it is unnecessary to separately form a readout resonator. A compact electronic circuit is obtained.

For example, instead of linear resonators, transmons are used as the first and second filter resonators 41f and 42f. In such a case, the input of the transmon is set to be sufficiently weak. The first resonator 11R strongly couples with the first qubit 51B, causing a large state-dependent frequency shift. For example, due to the strong coupling, the state-dependent frequency shift is about 30 MHz, and the states of the qubits can be read out.

For example, for an output signal loss of about 50%, a readout error probability of lower than 1% is obtained for a readout period of 200 ns.

FIG. 3 is a schematic view illustrating characteristics of the electronic circuit according to the first embodiment.

FIG. 3 illustrates the pass characteristic of the first filter 31F. The horizontal axis of FIG. 3 is a frequency fr1. The vertical axis is a transmittance Tr. As described above, the first filter 31F may include the first filter resonator 41f and the second filter resonator 42f. FIG. 3 illustrates the pass characteristics of the first and second filter resonators 41f and 42f. As shown in FIG. 3, the first filter 31F includes a passband 50p, a first non-pass band 50r, and a second non-pass band 50s. The frequency fr1 in the passband 50p is greater than the frequency fr1 in the first non-pass band 50r. The frequency fr1 in the passband 50p is less than the frequency fr1 in the second non-pass band 50s. The non-pass band (e.g., the first non-pass band 50r) corresponds to the reflection band of the first filter 31F. The passbands of the first and second filter resonators 41f and 42f are included in the passband 50p.

FIG. 3 illustrates a resonant frequency f10A of the first coupler 10A. The resonant frequency f10A of the first coupler 10A includes the resonant frequency of the first resonator 11R and the resonant frequency of the second resonator 12R. The passband 50p of the first filter 31F includes the resonant frequency of the first resonator 11R and the resonant frequency of the second resonator 12R.

FIG. 3 illustrates a frequency f50 of the qubits. The frequency f50 of the qubits includes the resonant frequency of the first qubit 51B and the resonant frequency of the second qubit 52B. The reflection band of the first filter 31F includes the frequency f50 of the qubits (the resonant frequency of the first qubit 51B and the resonant frequency of the second qubit 52B).

According to the embodiment, the first filter 31F transmits the resonant frequency of the first resonator 11R in the idling state. The first filter 31F substantially does not transmit the resonant frequency of the first qubit 51B. Such a first filter 31F is coupled with the first readout conductive member 21. The first readout conductive member 21 functions as a readout line. According to the embodiment, high-speed readout is possible. According to the embodiment, good qubit coherence time (high gate fidelity) is obtained.

According to the embodiment, for example, the passband of the first filter 31F includes the resonant frequency of the first resonator 11R when a first coupling strength is substantially zero.

In one example, the absolute value of the difference between the resonant frequency of the first resonator 11R and the resonant frequency of the first qubit 51B may be greater than the absolute value of the difference between the resonant frequency of the first resonator 11R and the resonant frequency of the second resonator 12R. The absolute value of the difference between the resonant frequency of the second resonator 12R and the resonant frequency of the second qubit 52B may be greater than the absolute value of the difference between the resonant frequency of the first resonator 11R and the resonant frequency of the second resonator 12R.

In one example, the absolute value of the difference between the resonant frequency of the first qubit 51B and the resonant frequency of the second qubit 52B may be less than the absolute value of the difference between the resonant frequency of the first resonator 11R and the resonant frequency of the first qubit 51B. The absolute value of the difference between the resonant frequency of the first qubit 51B and the resonant frequency of the second qubit 52B may be less than the absolute value of the difference between the resonant frequency of the second resonator 12R and the resonant frequency of the second qubit 52B.

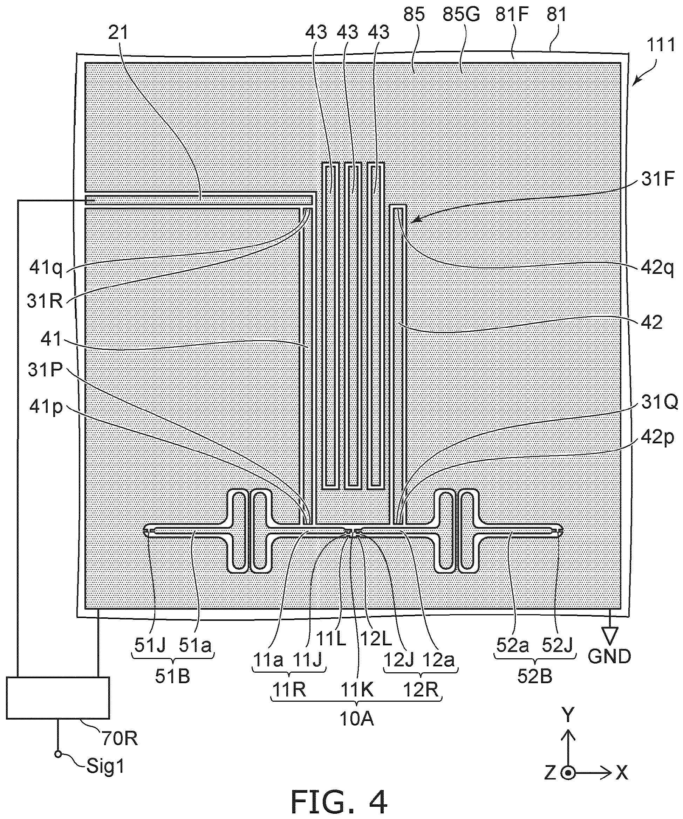

FIG. 4 is a schematic plan view illustrating an electronic circuit according to the first embodiment.

As shown in FIG. 4, the electronic circuit 111 according to the embodiment includes the first qubit 51B, the second qubit 52B, the first coupler 10A, the first readout conductive member 21, and the first filter 31F. The configuration of the first filter 31F of the electronic circuit 111 is different from the configuration of the first filter 31F of the electronic circuit 110. Otherwise, the configuration of the electronic circuit 111 may be similar to the configuration of the electronic circuit 110.

In the electronic circuit 111, the first filter 31F includes the first conductive member 41, the second conductive member 42, and at least one third conductive member 43. The third conductive member 43 is located between the first conductive member 41 and the second conductive member 42. Multiple third conductive members 43 may be included. In the example, three third conductive members 43 are located between the first conductive member 41 and the second conductive member 42. The third conductive members 43 are couplable with the first and second conductive members 41 and 42.

The first conductive member 41 includes the first conductive portion 41p and the first other-conductive portion 41q. The first conductive portion 41p is couplable with the first resonator 11R. The second conductive member 42 is couplable with the second resonator 12R. The first other-conductive portion 41q is couplable with the first readout conductive member 21. The second conductive member 42 includes the second conductive portion 42p and the second other-conductive portion 42q. The second conductive portion 42p is couplable with the second resonator 12R.

The first conductive portion 41p corresponds to the first filter portion 31P. The second conductive member 42 (the second conductive portion 42p) corresponds to the first other-filter portion 31Q. The first other-conductive portion 41q corresponds to the first readout portion 31R.

In the first filter 31F of the electronic circuit 111, the steepness of the change of the transmittance Tr between the passband 50p and the non-pass band can be improved. For example, the readout speed is increased. For example, the performance related to the qubit coherence time (a high gate fidelity) is improved.

For example, the first filter 31F transmits the resonant frequency of the first resonator 11R in the idling state and the resonant frequency of the second resonator 12R in the idling state. The first filter 31F substantially does not transmit the frequencies of the qubits in a wide bandwidth. A steep bandpass filter is obtained.

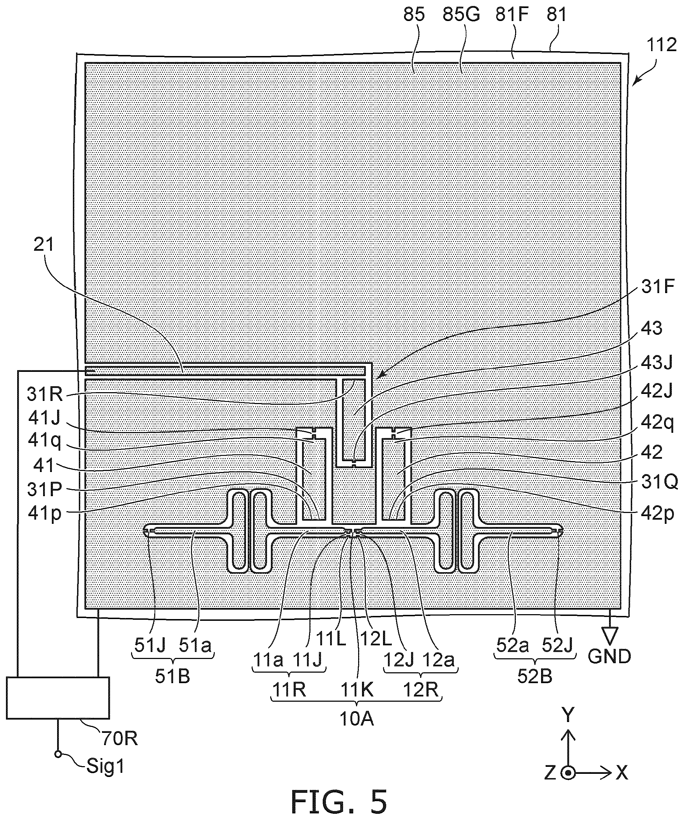

FIG. 5 is a schematic plan view illustrating an electronic circuit according to the first embodiment.

As shown in FIG. 5, the electronic circuit 112 according to the embodiment includes the first qubit 51B, the second qubit 52B, the first coupler 10A, the first readout conductive member 21, and the first filter 31F. The configuration of the first filter 31F of the electronic circuit 112 is different from the configuration of the first filter 31F of the electronic circuit 110. Otherwise, the configuration of the electronic circuit 112 may be similar to the configuration of the electronic circuit 110.

In the electronic circuit 112, the first filter 31F includes the first conductive member 41, the second conductive member 42, and the third conductive member 43. The first conductive member 41 is couplable with the first resonator 11R. The second conductive member 42 is couplable with the second resonator 12R. The third conductive member 43 is couplable with the first readout conductive member 21. At least a portion of the third conductive member 43 is located between the first conductive member 41 and the second conductive member 42.

For example, the first filter 31F includes a first conductive member Josephson junction 41J, a second conductive member Josephson junction 42J, and a third conductive member Josephson junction 43J. The first conductive member Josephson junction 41J is couplable with the first conductive member 41. The second conductive member Josephson junction 42J is couplable with the second conductive member 42. The third conductive member Josephson junction 43J is couplable with the third conductive member 43.

For example, the first filter 31F is based on a transmon resonator. According to the embodiment, the first coupler 10A is a double-transmon coupler. The transmon of the first coupler 10A functions as a readout resonator. By applying the first filter 31F based on the transmon resonator, even better space conservation is possible.

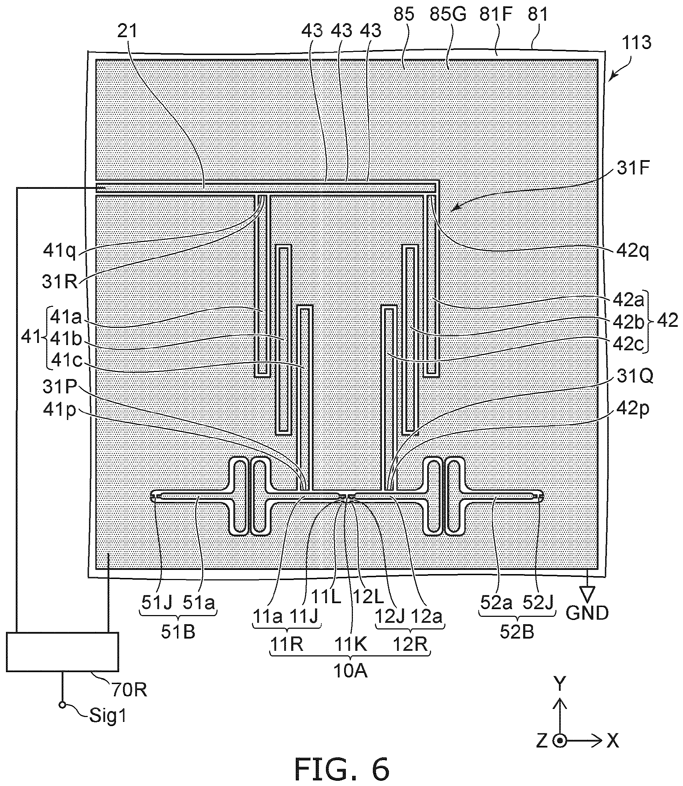

FIG. 6 is a schematic plan view illustrating an electronic circuit according to the first embodiment.

In the electronic circuit 113 according to the embodiment as shown in FIG. 6, the configurations of the first and second conductive members 41 and 42 included in the first filter 31F are different from the configurations of the electronic circuit 110. Otherwise, the configuration of the electronic circuit 113 may be similar to the configuration of the electronic circuit 110.

In the electronic circuit 113, the first conductive member 41 includes multiple first filter conductive parts (conductive parts 41a to 41c, etc.). The second conductive member 42 includes multiple second filter conductive parts (conductive parts 42a to 42c, etc.). The multiple first filter conductive parts (the conductive parts 41a to 41c) are mutually couplable. The multiple second filter conductive parts (the conductive parts 42a to 42c, etc.) are mutually couplable.

For example, the first conductive portion 41p is included in one of the multiple first filter conductive parts. For example, the first other-conductive portion 41q is included in another one of the multiple first filter conductive parts. The second conductive portion 42p is included in one of the multiple second filter conductive parts. The second other-conductive portion 42q is included in another one of the multiple second filter conductive parts.

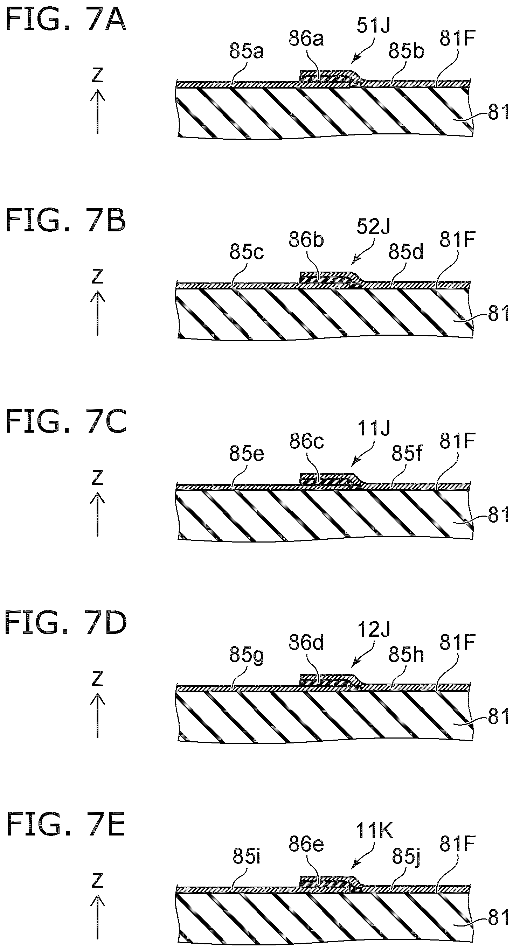

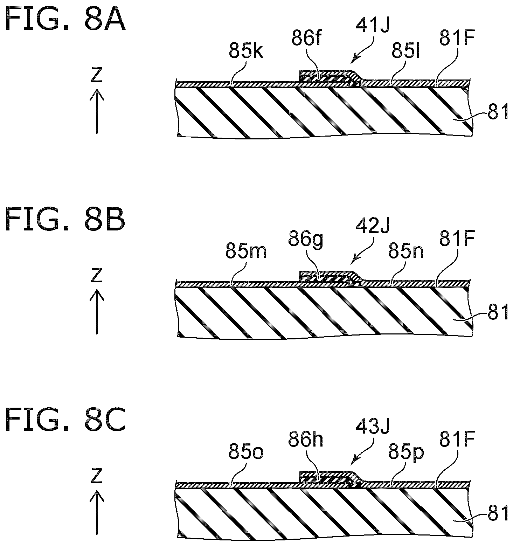

FIGS. 7A to 7E and FIGS. 8A to 8C are schematic cross-sectional views illustrating portions of the electronic circuit according to the first embodiment.

In the first bit Josephson junction 51J as shown in FIG. 7A, a conductive film 85a and a conductive film 85b face each other on the first surface 81F of the first base body 81. An insulating film 86a is located between a portion of the conductive film 85a and a portion of the conductive film 85b.

In the second bit Josephson junction 52J as shown in FIG. 7B, a conductive film 85c and a conductive film 85d face each other on the first surface 81F of the first base body 81. An insulating film 86b is located between a portion of the conductive film 85c and a portion of the conductive film 85d.

In the first resonator Josephson junction 11J as shown in FIG. 7C, a conductive film 85e and a conductive film 85f face each other on the first surface 81F of the first base body 81. An insulating film 86c is located between a portion of the conductive film 85e and a portion of the conductive film 85f.

In the second resonator Josephson junction 12J as shown in FIG. 7D, a conductive film 85g and a conductive film 85h face each other on the first surface 81F of the first base body 81. An insulating film 86d is located between a portion of the conductive film 85g and a portion of the conductive film 85h.

In the first coupler Josephson junction 11K as shown in FIG. 7E, a conductive film 85i and a conductive film 85j face each other on the first surface 81F of the first base body 81. An insulating film 86e is located between a portion of the conductive film 85i and a portion of the conductive film 85j.

In the first conductive member Josephson junction 41J as shown in FIG. 8A, a conductive film 85k and a conductive film 851 face each other on the first surface 81F of the first base body 81. An insulating film 86f is located between a portion of the conductive film 85k and a portion of the conductive film 85I.

In the second conductive member Josephson junction 42J as shown in FIG. 8B, a conductive film 85m and a conductive film 85n face each other on the first surface 81F of the first base body 81. An insulating film 86g is located between a portion of the conductive film 85m and a portion of the conductive film 85n.

In the third conductive member Josephson junction 43J as shown in FIG. 8C, a conductive film 85o and a conductive film 85p face each other on the first surface 81F of the first base body 81. An insulating film 86h is located between a portion of the conductive film 85o and a portion of the conductive film 85p.

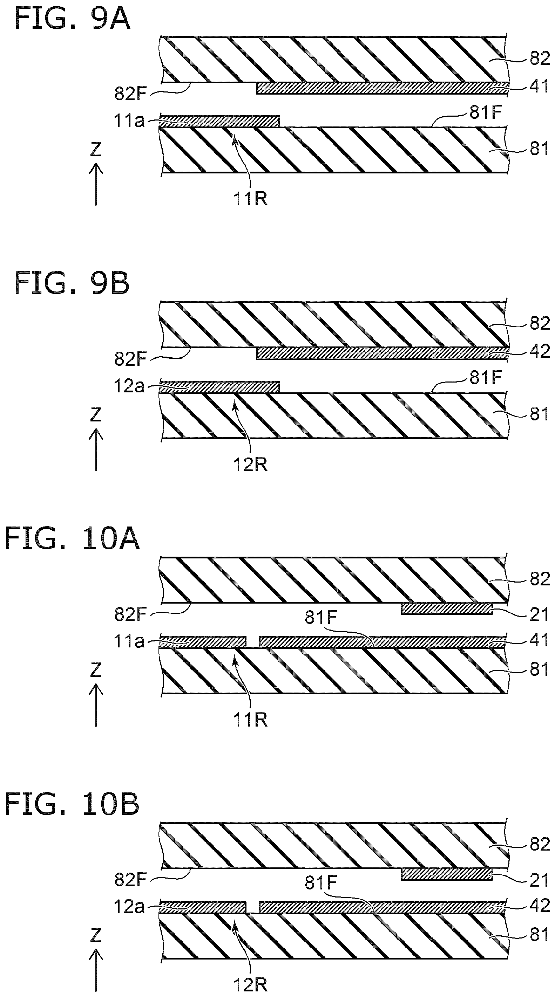

FIGS. 9A and 9B are schematic cross-sectional views illustrating portions of the electronic circuit according to the first embodiment.

As shown in FIG. 9A, the first resonator conductive part 11a may be located at the first surface 81F of one base body (e.g., the first base body 81). The first conductive member 41 may be located at a second surface 82F of another base body (e.g., a second base body 82). The second surface 82F faces the first surface 81F.

As shown in FIG. 9B, the second resonator conductive part 12a may be located at the first surface 81F of one base body (e.g., the first base body 81). The second conductive member 42 may be located at the second surface 82F of another base body (e.g., the second base body 82).

FIGS. 10A and 10B are schematic cross-sectional views illustrating portions of the electronic circuit according to the first embodiment.

As shown in FIG. 10A, the first conductive member 41 may be located at one base body. The first readout conductive member 21 may be located at another base body. The one base body may be, for example, one of the first base body 81 or the second base body 82. The other one base body may be, for example, the other of the first base body 81 or the second base body 82.

As shown in FIG. 10B, the second conductive member 42 may be located at one base body. The first readout conductive member 21 may be located at another base body. The one base body may be, for example, one of the first base body 81 or the second base body 82. The other one base body may be, for example, the other of the first base body 81 or the second base body 82.

The first resonator conductive part 11a may be located at the first surface 81F of one base body (e.g., the first base body 81); and the first conductive member 41 may be located at another surface (e.g., the back surface) of the one base body (e.g., the first base body 81). The second resonator conductive part 12a may be located at the first surface 81F of one base body (e.g., the first base body 81); and the second conductive member 42 may be located at another surface (e.g., the back surface) of the one base body (e.g., the first base body 81).

The first conductive member 41 may be located at one surface of one base body; and the first readout conductive member 21 may be located at another surface (e.g., the back surface) of the one base body. The second conductive member 42 may be located at one surface of one base body; and the first readout conductive member 21 may be located at another surface (e.g., the back surface) of the one base body.

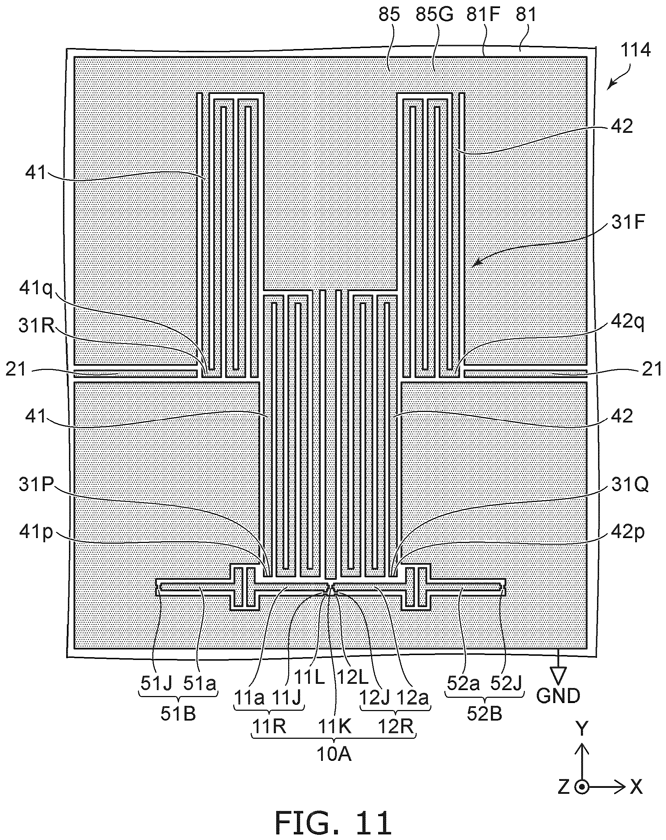

FIG. 11 is a schematic plan view illustrating an electronic circuit according to the first embodiment.

In the electronic circuit 114 according to the embodiment as shown in FIG. 11, the first coupler 10A is couplable with multiple first readout conductive members 21 via the first filter 31F.

In the electronic circuit 114, the first filter 31F includes the multiple first conductive members 41 and the multiple second conductive members 42. The multiple first conductive members 41 are mutually couplable. The multiple second conductive members 42 are mutually couplable. A portion of one of the multiple first conductive members 41 corresponds to the first conductive portion 41p. A portion of another one of the multiple first conductive members 41 corresponds to the first other-conductive portion 41q. A portion of one of the multiple second conductive members 42 corresponds to the second conductive portion 42p. A portion of another one of the multiple second conductive members 42 corresponds to the second other-conductive portion 42q.

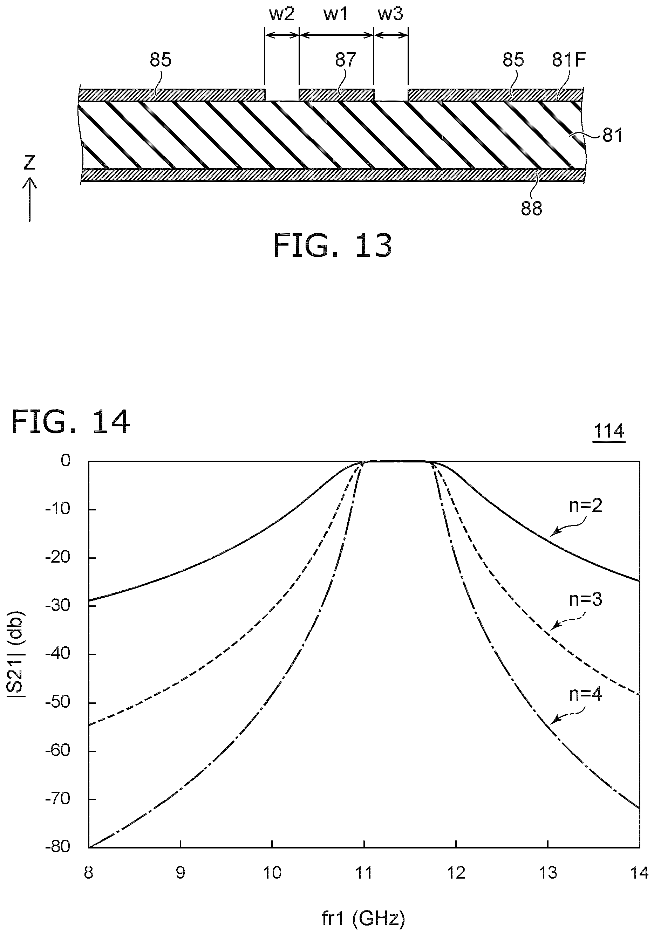

Portions (e.g., end portions) of the multiple first conductive members 41 and portions (e.g., end portions) of the multiple second conductive members 42 are connected with the ground conductive layer 85G. In the example, the portions of the multiple first conductive members 41 and the portions of the multiple second conductive members 42 are connected with the conductive layer 85 (the ground conductive layer 85G) located around these conductive members. The portions of the multiple first conductive members 41 and the portions of the multiple second conductive members 42 may be electrically connected with a conductive layer 88 located at the back surface of the first base body 81 (see FIG. 13) by a through-connection part located in the first base body 81. The conductive layer 88 functions as the ground conductive layer 85G.

Thus, the first filter 31F may include multiple conductive members. The number *n* of the conductive members is 2 when the multiple conductive members include the one first conductive member 41 and the one second conductive member 42. The number *n* of the multiple conductive members is 3 when the multiple conductive members include one first conductive member 41, one second conductive member 42, and one third conductive member 43. In the electronic circuit 114, the number *n* of the multiple conductive members is 4.

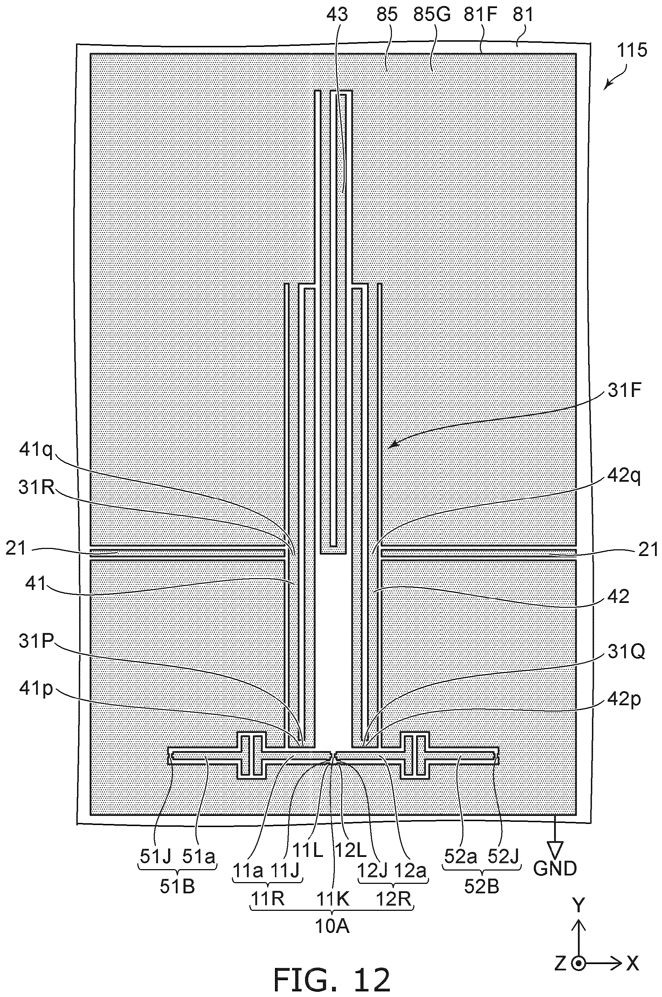

FIG. 12 is a schematic plan view illustrating an electronic circuit according to the first embodiment.

In the electronic circuit 115 according to the embodiment as shown in FIG. 12, the first coupler 10A is couplable with the multiple first readout conductive members 21 via the first filter 31F. The first filter 31F includes the first conductive member 41, the second conductive member 42, and the third conductive member 43. The first conductive member 41 faces a portion of the third conductive member 43. The first conductive member 41 is couplable with a portion of the third conductive member 43. The second conductive member 42 corresponds to another portion of the third conductive member 43. The second conductive member 42 is couplable with another portion of the third conductive member 43. In the electronic circuits 114 and 115 as well, electronic circuits can be provided in which the characteristics can be improved.

In the electronic circuit 115, portions (e.g., end portions) of the first conductive member 41, the second conductive member 42, and the third conductive member 43 are connected with the ground conductive layer 85G. In the example, the portions of the first conductive member 41, the second conductive member 42, and the third conductive member 43 are connected with the conductive layer 85 (the ground conductive layer 85G) located around these conductive members. The portions of the first conductive member 41, the second conductive member 42, and the third conductive member 43 may be electrically connected with the conductive layer 88 located at the back surface of the first base body 81 (see FIG. 13) by a through-connection part. The conductive layer 88 functions as the ground conductive layer 85G.

An example of simulation results of characteristics of the electronic circuits 114 and 115 will now be described.

FIG. 13 is a schematic cross-sectional view illustrating the electronic circuit according to the first embodiment.

FIG. 13 illustrates a simulation model. As shown in FIG. 13, the conductive layer 85 and a conductive layer 87 that are located at the first surface 81F of the first base body 81 are included. The conductive layer 87 corresponds to the first conductive member 41, the second conductive member 42, or the third conductive member 43. The conductive layer 88 is located at the back surface of the first base body 81. In the simulation, the first base body 81 has the dielectric constant of silicon. The thickness of the first base body 81 is 300 µm. A width w1 (the length in a direction crossing the extension direction) of the conductive layer 87 is 20 µm. A distance w2 and a distance w3 between the conductive layer 85 and the conductive layer 87 are 10 µm. For simplicity in the simulation, the thicknesses of the conductive layer 85, the conductive layer 87, and the conductive layer 88 are set to 0.

FIG. 14 is a graph illustrating characteristics of the electronic circuit according to the first embodiment.

FIG. 14 illustrates the pass characteristic of the first filter 31 for the pattern of the electronic circuit 114. The horizontal axis of FIG. 14 is the frequency. The vertical axis is an insertion loss S21. FIG. 14 shows examples in which the number *n* of the multiple conductive members included in the first filter 31F is 2, 3, and 4.

As shown in FIG. 14, a good pass characteristic is obtained in the electronic circuit 114. A low insertion loss S21 is obtained as the number *n* of the multiple conductive members increases.

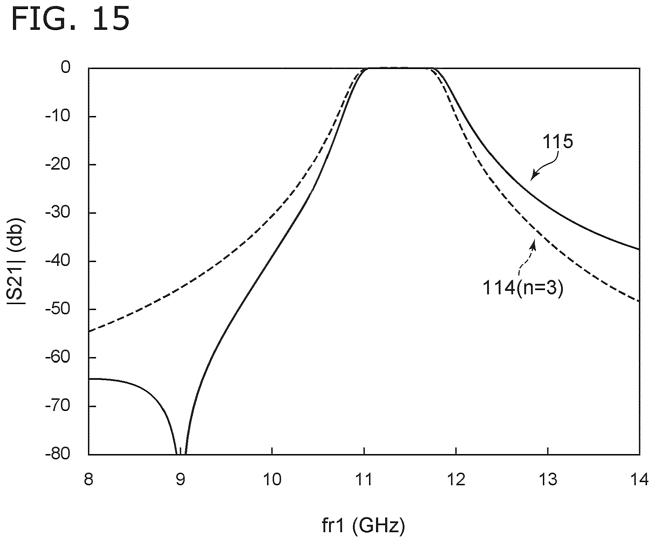

FIG. 15 is a graph illustrating characteristics of the electronic circuit according to the first embodiment.

FIG. 15 illustrates the pass characteristic of the first filter 31 for the pattern of the electronic circuit 115. FIG. 15 shows the characteristic of the electronic circuit 114 illustrated in FIG. 14 when the number *n* of the multiple conductive members is 3. The horizontal axis of FIG. 15 is the frequency. The vertical axis is the insertion loss S21. In the electronic circuit 115 as shown in FIG. 15, a frequency band at which an insertion loss S2 is markedly low is obtained. This frequency band corresponds to the resonant frequencies of the qubits. Better cutoff characteristics and pass characteristics are obtained in the electronic circuit 115. A stable readout operation can be performed.

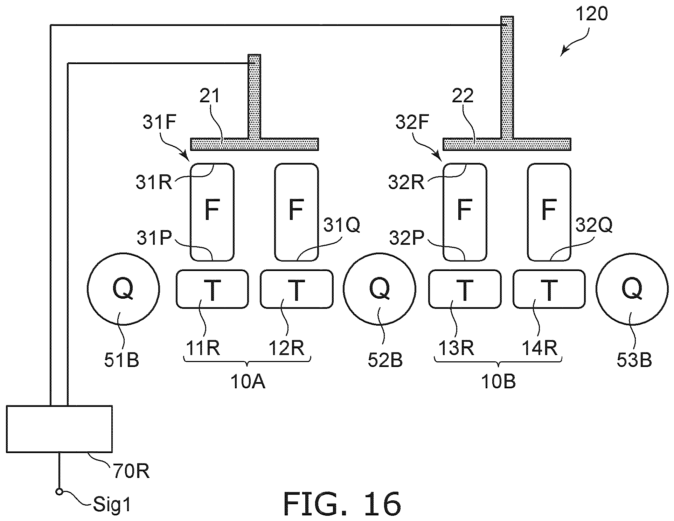

FIG. 16 is a schematic view illustrating an electronic circuit according to the first embodiment.

As shown in FIG. 16, the electronic circuit 120 according to the embodiment includes the first qubit 51B, the second qubit 52B, the first coupler 10A, the first readout conductive member 21, and the first filter 31F. The electronic circuit 120 further includes a third qubit 53B, a second coupler 10B, a second filter 32F, and a second readout conductive member 22. Otherwise, the configuration of the electronic circuit 120 may be similar to the configuration of the electronic circuit 110.

The second coupler 10B includes a third resonator 13R that is couplable with the second qubit 52B, and a fourth resonator 14R that is couplable with the third qubit 53B. The second filter 32F includes a second filter portion 32P, a second other-filter portion 32Q, and a second readout portion 32R. The second filter portion 32P is couplable with the third resonator 13R. The second other-filter portion 32Q is couplable with the fourth resonator 14R. The second readout portion 32R is couplable with the second readout conductive member 22. For example, the readout circuit 70R may be electrically connected with the second readout conductive member 22.

In the electronic circuit 120, the state of the second qubit 52B may be read out via the second coupler 10B and the second filter 32F. The state of the third qubit 53B may be read out via the second coupler 10B and the second filter 32F. Better space conservation is possible.

The configuration of the first filter 31F described with reference to the electronic circuits 111 and 112 is applicable to the second filter 32F.

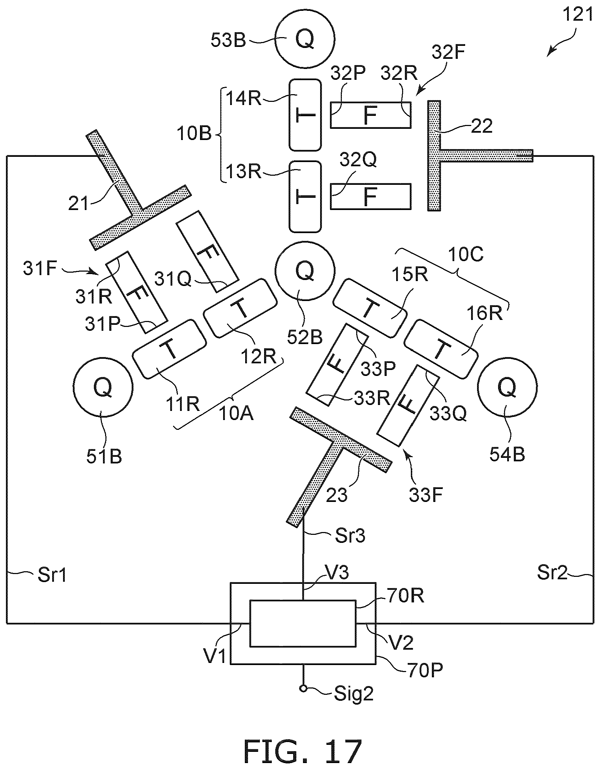

FIG. 17 is a schematic view illustrating an electronic circuit according to the first embodiment.

As shown in FIG. 17, the electronic circuit 121 according to the embodiment further includes a fourth qubit 54B, a third coupler 10C, a third filter 33F, and a third readout conductive member 23. Otherwise, the configuration of the electronic circuit 121 may be similar to the configuration of the electronic circuit 120.

The third coupler 10C includes a fifth resonator 15R that is couplable with the second qubit 52B, and a sixth resonator 16R that is couplable with the fourth qubit 54B. The third filter 33F includes a third filter portion 33P, a third other-filter portion 33Q, and a third readout portion 33R. The third filter portion 33P is couplable with the fifth resonator 15R. The third other-filter portion 33Q is couplable with the sixth resonator 16R. The third readout portion 33R is couplable with the third readout conductive member 23. For example, the readout circuit 70R may be electrically connected with the third readout conductive member 23.

In the electronic circuit 121, the state of the second qubit 52B may be read out via the third coupler 10C and the third filter 33F. The state of the fourth qubit 54B may be read out via the third coupler 10C and the third filter 33F. Better space conservation is possible.

In the electronic circuits 120 and 121, "Q" corresponds to a qubit. "T" corresponds to a transmon. "F" corresponds to a filter (e.g., a Purcell filter, etc.).

In the electronic circuit 121, the state of the second qubit 52B can be read out by a first circuit set, a second circuit set, and a third circuit set. The first circuit set includes the first coupler 10A and the first filter 31F. The second circuit set includes the second coupler 10B and the second filter 32F. The third circuit set includes the third coupler 10C and the third filter 33F. The states of the qubits can be determined based on "majority voting" by using the readout operations via the three sets of circuits.

For example, a signal processor 70P may be included as shown in FIG. 17. The signal processor 70P may be included in the electronic circuit 121. The signal processor 70P may be provided separately from the electronic circuit 121.

The signal processor 70P is configured to acquire a first readout signal Sr1, a second readout signal Sr2, and a third readout signal Sr3. The first readout signal Sr1 is obtained from the first readout conductive member 21. The second readout signal Sr2 is obtained from the second readout conductive member 22. The third readout signal Sr3 is obtained from the third readout conductive member 23.

The signal processor 70P is configured to compare a first readout value V1 related to the first readout signal Sr1, a second readout value V2 related to the second readout signal Sr2, and a third readout value V3 related to the third readout signal Sr3. The signal processor 70P is configured to output a value Sig2 among the first readout value V1, the second readout value V2, and the third readout value V3 that has the smallest difference from the other values among the first readout value V1, the second readout value V2, and the third readout value V3. For example, a more accurate determination can be made by majority voting.

### Second embodiment

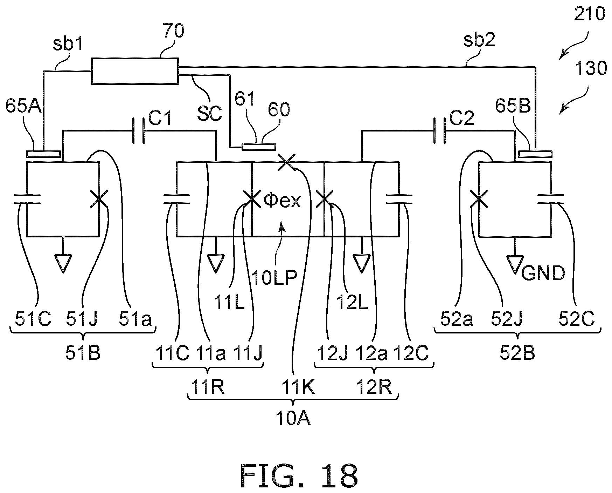

FIG. 18 is a schematic view illustrating an electronic circuit and a calculating device according to a second embodiment.

As shown in FIG. 18, the electronic circuit 130 according to the embodiment includes the magnetic flux controller 60. Otherwise, the configuration of the electronic circuit 130 may be the configuration of any electronic circuit described in reference to the first embodiment.

The magnetic flux controller 60 is configured to control the magnetic flux Φ of the space inside the loop 10LP. As described above, the loop 10LP includes the conductive path including the first coupler Josephson junction 11K, the conductive path including the first resonator Josephson junction 11J, and the conductive path including the second resonator Josephson junction 12J.

In the example, the magnetic flux controller 60 includes a first control conductive part 61. For example, a controller 70 may be included. For example, the controller 70 controls the magnetic flux Φ inside the loop 10LP by controlling the magnetic flux controller 60. For example, the controller 70 supplies a magnetic flux control signal Sc to the first control conductive part 61. Thereby, the controller 70 controls the magnetic flux Φ inside the loop 10LP. A calculating device 210 according to the embodiment includes the electronic circuit 130 and the controller 70.

The controller 70 is configured to perform at least a first operation and a second operation. In the first operation, the controller 70 is configured to change the magnetic flux Φ of the space inside the loop 10LP between a first value and a second value. The second value is different from the first value. The controller 70 performs a two-qubit operation of the first and second qubits 51B and 52B by changing the magnetic flux Φ. In the second operation, the controller 70 performs the two-qubit operation of the first and second qubits 51B and 52B by modulating the magnetic flux Φ by using an alternating current.

The electronic circuit 130 may include a first qubit controller 65A and a second qubit controller 65B. The controller 70 is configured to supply a first qubit control signal Sb1 to the first qubit controller 65A. The controller 70 is configured to supply a second qubit control signal Sb2 to the second qubit controller 65B. The states of the qubits can be controlled by controlling these signals.

Hereinabove, exemplary embodiments of the invention are described with reference to specific examples. However, the embodiments of the invention are not limited to these specific examples. For example, one skilled in the art may similarly practice the invention by appropriately selecting specific configurations of components included in electronic circuits and calculating devices such as non-linear elements, Josephson junctions, capacitors, conductive members, etc., from known art. Such practice is included in the scope of the invention to the extent that similar effects thereto are obtained.

While certain embodiments have been described, these embodiments have been presented by way of example only, and are not intended to limit the scope of the inventions. Indeed, the novel embodiments described herein may be embodied in a variety of other forms.

## Claims

1. An electronic circuit (110), comprising:
a first qubit (51B);
a second qubit (52B);
a first coupler (10A) including a first resonator (11R) and a second resonator (12R), the first resonator (11R) being couplable with the first qubit (51B), the second resonator (12R) being couplable with the second qubit (52B); and
a first readout conductive member (21);
**characterized in that** it further comprises:
a first filter (31F) including a first filter portion (31P), a first other-filter portion (31Q), and a first readout portion (31R);
wherein the first filter portion (31P) is couplable with the first resonator (11R) and the first other-filter portion (31Q) is couplable with the second resonator (12R);
wherein the first readout portion (31R) is couplable with the first readout conductive member (21);
wherein the first filter (31F) substantially cuts off the resonant frequencies of the first qubit (51B), of the second qubit (52B) and allows the resonant frequency of the first resonator (11R) and the resonant frequency of the second resonator (12R), to thereby allow the first readout conductive member (21) to read out the states of the first qubit (51B) and of the second qubit (52B).

2. The electronic circuit (110) according to claim 1, wherein the first filter (31F) includes:
a first conductive member (41) including a first conductive portion (41p) and a first other-conductive portion (41q); and
a second conductive member (42) including a second conductive portion and a second other-conductive portion,
the first conductive portion (41p) is couplable with the first resonator (11R),
the second conductive portion is couplable with the second resonator,
the first other-conductive portion (41q) is couplable with the first readout conductive member (21), and
the second other-conductive portion is couplable with the first readout conductive member (21).

3. The electronic circuit (110) according to claim 1, wherein the first filter (31F) includes:
a first conductive member (41) including a first conductive portion (41p) and a first other-conductive portion (41q);
a second conductive member; and
at least one third conductive member located between the first conductive member (41) and the second conductive member,
the third conductive member is couplable with the first and second conductive members,
the first conductive portion (41p) is couplable with the first resonator (11R),
the second conductive member (42) is couplable with the second resonator, and
the first other-conductive portion (41q) is couplable with the first readout conductive member (21).

4. The electronic circuit (110) according to claim 1, wherein the first filter (31F) includes:
a first conductive member (41) couplable with the first resonator (11R);
a second conductive member (42) couplable with the second resonator; and
a third conductive member couplable with the first readout conductive member (21), and
at least a portion of the third conductive member is located between the first conductive member (41) and the second conductive member.

5. The electronic circuit (110) according to claim 4, wherein the first filter (31F) further includes:
a first conductive member Josephson junction couplable with the first conductive member;
a second conductive member Josephson junction couplable with the second conductive member; and
a third conductive member Josephson junction couplable with the third conductive member.

6. The electronic circuit (110) according to any one of claims 1-5, wherein
a resonant frequency of the first resonator (11R) is greater than a resonant frequency of the first qubit (51B),
a resonant frequency of the second resonator (12R) is greater than a resonant frequency of the second qubit,
an absolute value of a difference between the resonant frequency of the first resonator (11R) and the resonant frequency of the first qubit (51B) is greater than an absolute value of a difference between the resonant frequency of the first resonator (11R) and the resonant frequency of the second resonator, and
an absolute value of a difference between the resonant frequency of the second resonator (12R) and the resonant frequency of the second qubit (52B) is greater than the absolute value of the difference between the resonant frequency of the first resonator (11R) and the resonant frequency of the second resonator.

7. The electronic circuit (110) according to claim 6, wherein
an absolute value of a difference between the resonant frequency of the first qubit (51B) and the resonant frequency of the second qubit (52B) is less than the absolute value of the difference between the resonant frequency of the first resonator (11R) and the resonant frequency of the first qubit (51B) and less than the absolute value of the difference between the resonant frequency of the second resonator (12R) and the resonant frequency of the second qubit.

8. The electronic circuit (110) according to any one of claims 1-5, wherein
the first resonator (11R) includes a first inductor and a first capacitor,
the first capacitor is connected in parallel with the first inductor,
the second resonator (12R) includes a second inductor and a second capacitor,
the second capacitor is connected in parallel with the second inductor,
the first coupler (10A) further includes a first coupler Josephson junction,
one end of the first coupler Josephson junction is connected with one end of the first inductor and one end of the first capacitor, and
an other end of the first coupler Josephson junction is connected with one end of the second inductor and one end of the second capacitor.

9. The electronic circuit (110) according to claim 8, wherein
the first inductor includes at least one first resonator Josephson junction, and
the second inductor includes at least one second resonator Josephson junction.

10. The electronic circuit (110) according to claim 9, wherein
a coupling strength between the first qubit (51B) and the second qubit (52B) is controllable by controlling a magnetic flux inside a loop, and
the loop includes:
a conductive path including the first coupler Josephson junction,
a conductive path including the first resonator Josephson junction, and
a conductive path including the second resonator Josephson junction.

11. The electronic circuit (110) according to claim 10, wherein
a passband of the first filter (31F) includes a resonant frequency of the first resonator (11R) when the first coupling strength is substantially zero, and
the passband of the first filter (31F) includes a resonant frequency of the second resonator (12R) when the second coupling strength is substantially zero.

12. The electronic circuit (110) according to claim 1, further comprising:
a third qubit;
a second coupler;
a second filter; and
a second readout conductive member,
the second coupler including
a third resonator couplable with the second qubit, and
a fourth resonator couplable with the third qubit,
the second filter including a second filter portion, a second other-filter portion, and a second readout portion,
the second filter portion being couplable with the third resonator,
the second other-filter portion being couplable with the fourth resonator,
the second readout portion being couplable with the second readout conductive member.

13. The electronic circuit (110) according to claim 10, further comprising:
a magnetic flux controller (60) configured to control the magnetic flux in a space inside the loop.

14. A calculating device, comprising:
the electronic circuit (110) according to claim 13; and
a controller (70),
the magnetic flux controller (60) includes a first control conductive part, and
the controller (70) is configured to supply a magnetic flux control signal to the first control conductive part.

## Patentansprüche

1. Eine elektronische Schaltung (110), umfassend:
ein erstes Qubit (51B);
ein zweites Qubit (52B);
einen ersten Koppler (10A) mit einem ersten Resonator (11R) und einem zweiten Resonator (12R), wobei der erste Resonator (11R) mit dem ersten Qubit (51B) koppelbar ist und der zweite Resonator (12R) mit dem zweiten Qubit (52B) koppelbar ist; und
ein erstes leitfähiges Ausleseelement (21); **dadurch gekennzeichnet, dass** diese weiter umfasst:
ein erstes Filter (31F) mit einem ersten Filterabschnitt (31P), einem ersten anderen Filterabschnitt (31Q) und einem ersten Ausleseabschnitt (31R);
wobei der erste Filterabschnitt (31P) mit dem ersten Resonator (11R) koppelbar ist und der erste andere Filterabschnitt (310) mit dem zweiten Resonator (12R) koppelbar ist;
wobei der erste Ausleseabschnitt (31R) mit dem ersten leitfähigen Ausleseelement (21) koppelbar ist;
wobei der erste Filter (31F) im Wesentlichen die Resonanzfrequenzen des ersten Qubits (51B), des zweiten Qubits (52B) abschneidet und die Resonanzfrequenz des ersten Resonators (11R) und die Resonanzfrequenz des zweiten Resonators (12R) durchzulassen, wodurch das erste Ausleseleitungselement (21) die Zustände des ersten Qubits (51B) und des zweiten Qubits (52B) auslesen kann.

2. Elektronische Schaltung (110) gemäß Anspruch 1, wobei das erste Filter (31F) umfasst:
ein erstes leitfähiges Element (41) mit einem ersten leitfähigen Abschnitt (41p) und einem ersten anderen leitfähigen Abschnitt (41q); und
ein zweites leitfähiges Element (42) mit einem zweiten leitfähigen Abschnitt und einem zweiten anderen leitfähigen Abschnitt,
wobei der erste leitfähige Abschnitt (41p) mit dem ersten Resonator (11R) gekoppelt werden kann,
der zweite leitfähige Abschnitt mit dem zweiten Resonator gekoppelt werden kann,
der erste nichtleitende Abschnitt (41q) mit dem ersten Ausleseleitungselement (21) gekoppelt werden kann und der zweite nichtleitende Abschnitt mit dem ersten Ausleseleitungselement (21) gekoppelt werden kann.

3. Elektronische Schaltung (110) gemäß Anspruch 1, wobei das erste Filter (31F) umfasst:
ein erstes leitfähiges Element (41) mit einem ersten leitfähigen Abschnitt (41p) und einem ersten anderen leitfähigen Abschnitt (41q);
ein zweites leitfähiges Element; und
mindestens ein drittes leitfähiges Element, das zwischen dem ersten leitfähigen Element (41) und dem zweiten leitfähigen Element angeordnet ist,
das dritte leitfähige Element mit dem ersten und dem zweiten leitfähigen Element gekoppelt werden kann,
der erste leitfähige Abschnitt (41p) mit dem ersten Resonator (11R) gekoppelt werden kann,
das zweite leitfähige Element (42) mit dem zweiten Resonator gekoppelt werden kann und
der erste andere leitfähige Abschnitt (41q) mit dem ersten Ausleseleitungselement (21) gekoppelt werden kann.

4. Elektronische Schaltung (110) gemäß Anspruch 1, wobei das erste Filter (31F) umfasst:
ein erstes leitfähiges Element (41), das mit dem ersten Resonator (11R) gekoppelt werden kann;
ein zweites leitfähiges Element (42), das mit dem zweiten Resonator gekoppelt werden kann; und
ein drittes leitfähiges Element, das mit dem ersten Ausleseleitungselement (21) gekoppelt werden kann, und
mindestens ein Teil des dritten leitfähigen Elements befindet sich zwischen dem ersten leitfähigen Element (41) und dem zweiten leitfähigen Element.

5. Elektronische Schaltung (110) gemäß Anspruch 4, wobei das erste Filter (31F) ferner umfasst:
ein erstes leitfähiges Element, das mit dem ersten leitfähigen Element koppelbar ist;
ein zweites leitfähiges Element, das mit dem zweiten leitfähigen Element koppelbar ist; und
ein drittes leitfähiges Element, das mit dem dritten leitfähigen Element koppelbar ist.

6. Elektronische Schaltung (110) gemäß einem der Ansprüche 1 bis 5, wobei
eine Resonanzfrequenz des ersten Resonators (11R) größer ist als eine Resonanzfrequenz des ersten Qubits (51B),
eine Resonanzfrequenz des zweiten Resonators (12R) größer ist als eine Resonanzfrequenz des zweiten Qubits,
der Absolutwert der Differenz zwischen der Resonanzfrequenz des ersten Resonators (11R) und der Resonanzfrequenz des ersten Qubits (51B) größer ist als der Absolutwert der Differenz zwischen der Resonanzfrequenz des ersten Resonators (11R) und der Resonanzfrequenz des zweiten Resonators, und
ein Absolutwert einer Differenz zwischen der Resonanzfrequenz des zweiten Resonators (12R) und der Resonanzfrequenz des zweiten Qubits (52B) größer ist als der Absolutwert der Differenz zwischen der Resonanzfrequenz des ersten Resonators (11R) und der Resonanzfrequenz des zweiten Resonators.

7. Elektronische Schaltung (110) gemäß Anspruch 6, wobei
der Absolutwert einer Differenz zwischen der Resonanzfrequenz des ersten Qubits (51B) und der Resonanzfrequenz des zweiten Qubits (52B) kleiner ist als der Absolutwert der Differenz zwischen der Resonanzfrequenz des ersten Resonators (11R) und der Resonanzfrequenz des ersten Qubits (51B) und kleiner als der Absolutwert der Differenz zwischen der Resonanzfrequenz des zweiten Resonators (12R) und der Resonanzfrequenz des zweiten Qubits ist.

8. Elektronische Schaltung (110) gemäß einem der Ansprüche 1 bis 5, wobei
der erste Resonator (11R) eine erste Induktivität und einen ersten Kondensator umfasst,
der erste Kondensator parallel zur ersten Induktivität geschaltet ist,
der zweite Resonator (12R) eine zweite Induktivität und einen zweiten Kondensator umfasst,
der zweite Kondensator parallel zur zweiten Induktivität geschaltet ist,
der erste Koppler (10A) ferner eine erste Koppler-Josephson-Verbindung umfasst,
ein Ende des ersten Koppler-Josephson-Übergangs mit einem Ende der ersten Induktivität und einem Ende des ersten Kondensators verbunden ist und
ein anderes Ende des ersten Koppler-Josephson-Übergangs mit einem Ende der zweiten Induktivität und einem Ende des zweiten Kondensators verbunden ist.

9. Elektronische Schaltung (110) gemäß Anspruch 8, wobei
der erste Induktor mindestens eine erste Resonator-Josephson-Verbindung umfasst und
der zweite Induktor mindestens eine zweite Resonator-Josephson-Verbindung umfasst.

10. Elektronische Schaltung (110) gemäß Anspruch 9, wobei
eine Kopplungsstärke zwischen dem ersten Qubit (51B) und dem zweiten Qubit (52B) durch Steuern eines Magnetflusses innerhalb einer Schleife steuerbar ist, und
die Schleife umfasst:
einen leitfähigen Pfad, der den ersten Koppler-Josephson-Übergang umfasst,
einen leitfähigen Pfad, der den ersten Resonator-Josephson-Übergang umfasst, und
einen leitfähigen Pfad, der den zweiten Resonator-Josephson-Übergang umfasst.

11. Elektronische Schaltung (110) gemäß Anspruch 10, wobei
ein Durchlassbereich des ersten Filters (31F) eine Resonanzfrequenz des ersten Resonators (11R) umfasst, wenn die erste Kopplungsstärke im Wesentlichen Null ist, und
der Durchlassbereich des ersten Filters (31F) eine Resonanzfrequenz des zweiten Resonators (12R) umfasst, wenn die zweite Kopplungsstärke im Wesentlichen Null ist.

12. Elektronische Schaltung (110) gemäß Anspruch 1, die ferner umfasst:
ein drittes Qubit;
einen zweiten Koppler;
ein zweites Filter; und
ein zweites leitfähiges Ausleseelement,
wobei der zweite Koppler umfasst
einen dritten Resonator, der mit dem zweiten Qubit koppelbar ist, und
einen vierten Resonator, der mit dem dritten Qubit gekoppelt werden kann,
wobei der zweite Filter einen zweiten Filterabschnitt, einen zweiten anderen Filterabschnitt und einen zweiten Ausleseabschnitt umfasst,
wobei der zweite Filterabschnitt mit dem dritten Resonator gekoppelt werden kann,
wobei der zweite andere Filterabschnitt mit dem vierten Resonator gekoppelt werden kann,
wobei der zweite Ausleseabschnitt mit dem zweiten leitfähigen Ausleseelement gekoppelt werden kann.

13. Elektronische Schaltung (110) gemäß Anspruch 10, die ferner umfasst:
einen Magnetflussregler (60), der so konfiguriert ist, dass er den Magnetfluss in einem Raum innerhalb der Schleife regelt.

14. Eine Rechenvorrichtung, die Folgendes umfasst:
die elektronische Schaltung (110) gemäß Anspruch 13; und
eine Steuereinheit (70),
wobei die Magnetflusssteuerung (60) ein erstes leitfähiges Steuerteil umfasst und
die Steuereinheit (70) so konfiguriert ist, dass sie ein Magnetflusssteuersignal an das erste leitfähige Steuerteil liefert.

## Revendications

1. Circuit électronique (110), comprenant :
un premier qubit (51B) ;
un deuxième qubit (52B) ;
un premier coupleur (10A) comprenant un premier résonateur (11R) et un deuxième résonateur (12R), le premier résonateur (11R) pouvant être couplé au premier qubit (51B), le deuxième résonateur (12R) pouvant être couplé au deuxième qubit (52B) ; et
un premier élément conducteur de lecture (21) ;
**caractérisé en ce qu'**il comprend en outre :
un premier filtre (31F) comprenant une première partie de filtre (31P), une première autre partie de filtre (310) et une première partie de lecture (31R) ;
dans lequel la première partie de filtre (31P) peut être couplée au premier résonateur (11R) et la première autre partie de filtre (310) peut être couplée au deuxième résonateur (12R) ;
dans lequel la première partie de lecture (31R) peut être couplée au premier élément conducteur de lecture (21) ; dans lequel le premier filtre (31F) coupe sensiblement les fréquences de résonance du premier qubit (51B) et du deuxième qubit (52B) et laisse passer la fréquence de résonance du premier résonateur (11R) et la fréquence de résonance du deuxième résonateur (12R), permettant ainsi au premier élément conducteur de lecture (21) de lire les états du premier qubit (51B) et du deuxième qubit (52B).

2. Circuit électronique (110) selon la revendication 1, dans lequel
le premier filtre (31F) comprend :
un premier élément conducteur (41) comprenant une première partie conductrice (41p) et une première autre partie conductrice (41q) ; et
un deuxième élément conducteur (42) comprenant une deuxième partie conductrice et une deuxième autre partie conductrice,
la première partie conductrice (41p) peut être couplée au premier résonateur (11R),
la deuxième partie conductrice peut être couplée au deuxième résonateur,
la première autre partie conductrice (41q) peut être couplée au premier élément conducteur de lecture (21), et
la deuxième autre partie conductrice peut être couplée au premier élément conducteur de lecture (21).

3. Circuit électronique (110) selon la revendication 1, dans lequel
le premier filtre (31F) comprend :
un premier élément conducteur (41) comprenant une première partie conductrice (41p) et une première autre partie conductrice (41q) ;
un deuxième élément conducteur ; et
au moins un troisième élément conducteur situé entre le premier élément conducteur (41) et le deuxième élément conducteur,
le troisième élément conducteur peut être couplé aux premier et deuxième éléments conducteurs,
la première partie conductrice (41p) peut être couplée au premier résonateur (11R),
le deuxième élément conducteur (42) peut être couplé au deuxième résonateur, et
la première autre partie conductrice (41q) peut être couplée au premier élément conducteur de lecture (21).

4. Circuit électronique (110) selon la revendication 1, dans lequel
le premier filtre (31F) comprend :
un premier élément conducteur (41) pouvant être couplé au premier résonateur (11R) ;
un deuxième élément conducteur (42) pouvant être couplé au deuxième résonateur ; et
un troisième élément conducteur pouvant être couplé au premier élément conducteur de lecture (21), et
au moins une partie du troisième élément conducteur est située entre le premier élément conducteur (41) et le deuxième élément conducteur.

5. Circuit électronique (110) selon la revendication 4, dans lequel
le premier filtre (31F) comprend en outre :
une jonction de Josephson de premier élément conducteur pouvant être couplée au premier élément conducteur ;
une jonction de Josephson de deuxième élément conducteur pouvant être couplée au deuxième élément conducteur ; et
une jonction de Josephson de troisième élément conducteur pouvant être couplée au troisième élément conducteur.

6. Circuit électronique (110) selon l'une quelconque des revendications 1 à 5, dans lequel
une fréquence de résonance du premier résonateur (11R) est supérieure à une fréquence de résonance du premier qubit (51B),
une fréquence de résonance du deuxième résonateur (12R) est supérieure à une fréquence de résonance du deuxième qubit,
une valeur absolue d'une différence entre la fréquence de résonance du premier résonateur (11R) et la fréquence de résonance du premier qubit (51B) est supérieure à une valeur absolue d'une différence entre la fréquence de résonance du premier résonateur (11R) et la fréquence de résonance du deuxième résonateur, et
une valeur absolue d'une différence entre la fréquence de résonance du deuxième résonateur (12R) et la fréquence de résonance du deuxième qubit (52B) est supérieure à la valeur absolue de la différence entre la fréquence de résonance du premier résonateur (11R) et la fréquence de résonance du deuxième résonateur.

7. Circuit électronique (110) selon la revendication 6, dans lequel
une valeur absolue d'une différence entre la fréquence de résonance du premier qubit (51B) et la fréquence de résonance du deuxième qubit (52B) est inférieure à la valeur absolue de la différence entre la fréquence de résonance du premier résonateur (11R) et la fréquence de résonance du premier qubit (51B) et inférieure à la valeur absolue de la différence entre la fréquence de résonance du deuxième résonateur (12R) et la fréquence de résonance du deuxième qubit.

8. Circuit électronique (110) selon l'une quelconque des revendications 1 à 5, dans lequel
le premier résonateur (11R) comprend une première inductance et un premier condensateur,
le premier condensateur est connecté en parallèle avec la première inductance,
le deuxième résonateur (12R) comprend une deuxième inductance et un deuxième condensateur,
le deuxième condensateur est connecté en parallèle avec la deuxième inductance,
le premier coupleur (10A) comprend en outre une première jonction de Josephson de coupleur,
une extrémité de la première jonction de Josephson de coupleur est connectée à une extrémité de la première inductance et à une extrémité du premier condensateur, et
une autre extrémité de la première jonction de Josephson de coupleur est connectée à une extrémité de la deuxième inductance et à une extrémité du deuxième condensateur.

9. Circuit électronique (110) selon la revendication 8, dans lequel
la première inductance comprend au moins une première jonction de Josephson de résonateur, et
la deuxième inductance comprend au moins une deuxième jonction de Josephson de résonateur.

10. Circuit électronique (110) selon la revendication 9, dans lequel
une force de couplage entre le premier qubit (51B) et le deuxième qubit (52B) est contrôlable en contrôlant un flux magnétique à l'intérieur d'une boucle, et
la boucle comprend :
un chemin conducteur comprenant la première jonction de Josephson de coupleur,
un chemin conducteur comprenant la première jonction de Josephson de résonateur, et
un chemin conducteur comprenant la deuxième jonction de Josephson de résonateur.

11. Circuit électronique (110) selon la revendication 10, dans lequel
une bande passante du premier filtre (31F) comprend une fréquence de résonance du premier résonateur (11R) lorsque la première force de couplage est substantiellement nulle, et
la bande passante du premier filtre (31F) comprend une fréquence de résonance du deuxième résonateur (12R) lorsque la deuxième force de couplage est substantiellement nulle.

12. Circuit électronique (110) selon la revendication 1, comprenant en outre :
un troisième qubit ;
un deuxième coupleur ;
un deuxième filtre ; et
un deuxième élément conducteur de lecture,
le deuxième coupleur comprenant
un troisième résonateur pouvant être couplé au deuxième qubit, et
un quatrième résonateur pouvant être couplé au troisième qubit,
le deuxième filtre comprenant une deuxième partie de filtre, une deuxième autre partie de filtre et une deuxième partie de lecture,
la deuxième partie de filtre pouvant être couplée au troisième résonateur,
la deuxième autre partie de filtre pouvant être couplée au quatrième résonateur,
la deuxième partie de lecture pouvant être couplée au deuxième élément conducteur de lecture.

13. Circuit électronique (110) selon la revendication 10, comprenant en outre :
un contrôleur de flux magnétique (60) configuré pour contrôler le flux magnétique dans un espace à l'intérieur de la boucle.

14. Dispositif de calcul, comprenant :
le circuit électronique (110) selon la revendication 13 ; et
un contrôleur (70),
le contrôleur de flux magnétique (60) comprend une première partie conductrice de contrôle, et
le contrôleur (70) est configuré pour fournir un signal de contrôle de flux magnétique à la première partie conductrice de contrôle.
